Europäisches Patentamt

European Patent Office

Office européen des brevets

(19)

(11) **EP 0 716 501 B1**

(12) **FASCICULE DE BREVET EUROPEEN**

(45) Date de publication et mention
de la délivrance du brevet:
**16.04.1997 Bulletin 1997/16**

(51) Int Cl.$^6$: **H03D 13/00**, H03L 7/089,
H03L 7/081

(21) Numéro de dépôt: **95402727.2**

(22) Date de dépôt: **04.12.1995**

(54) **Comparateur de phase entre un signal numérique et un signal d'horloge, et boucle à verrouillage de phase correspondante**

Phasenvergleicher für ein digitales Signal und ein Taktsignal, und entsprechender Phasenregelkreis

Phase comparator of a digital signal and a clock signal, and corresponding phase locked loop

(84) Etats contractants désignés:
**DE GB IT NL**

(30) Priorité: **08.12.1994 FR 9414780**

(43) Date de publication de la demande:
**12.06.1996 Bulletin 1996/24**

(73) Titulaire: **MATRA MHS**
**44087 Nantes Cédex 03 (FR)**

(72) Inventeur: **Neron, Christophe**
**F-44300 Nantes (FR)**

(74) Mandataire: **Fréchède, Michel et al**
**Cabinet Plasseraud**
**84, rue d'Amsterdam**
**F-75440 Paris Cédex 09 (FR)**

(56) Documents cités:
GB-A- 2 091 961          US-A- 5 053 649

• JOURNAL OF LIGHTWAVE TECHNOLOGY, vol. 3, no. 6, NEW YORK, USA, pages 1312-1314, CHARLES R. HOGGE, JR. 'A Self Correcting Clock Recovery Circuit'

**Description**

L'invention concerne un dispositif comparateur de phase entre un signal de données numériques d'entrée et un signal d'horloge, et la mise en oeuvre de ce dernier dans la technologie des circuits intégrés, pour assurer, à partir d'un signal de données numériques, la régénération locale d'un signal d'horloge de référence.

Pour régénérer un signal d'horloge de référence, en phase avec un signal de données numériques, on peut utiliser actuellement un comparateur de phase de Hogge dans une boucle à verrouillage de phase, laquelle permet de régénérer localement un signal d'horloge parfaitement synchronisé sur le flux incident des données traitées.

Un tel type de comparateur de phase a été décrit dans l'article publié par Charles R.Hogge, intitulé " *A Self Correcting Clock Recovery Circuit"*, Journal of Lightwave Technology, Vol. LT3, No.6, Décembre 1985 pages 1312-1314. Ce type de comparateur donne satisfaction et remplit simultanément les fonctions de régénération et de resynchronisation des données numériques, ainsi qu'une auto-correction du maintien en milieu de bit du front actif de l'horloge locale de référence. En outre, il présente une large excursion statique de phase caractérisée par une linéarité [-π, +π] et une indépendance de fonctionnement vis-à-vis de la fréquence du signal d'horloge de référence.

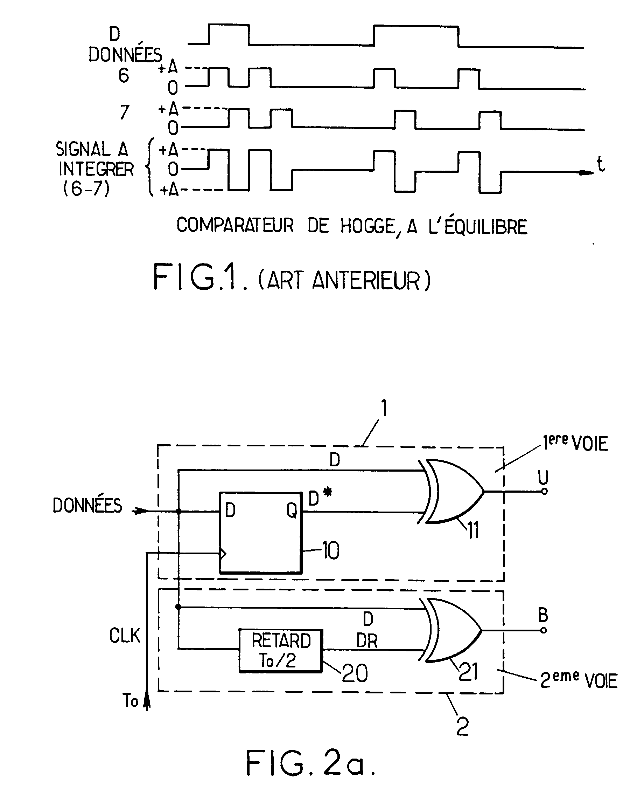

Cependant, une analyse des signaux des ports 6 et 7, en entrée du comparateur de sortie, tel que représenté en figure 1, relativement à un tel type de comparateur de l'art antérieur, montre que ceux-ci sont, à l'équilibre de phase, décalés de 180°. En conséquence, le signal à intégrer, délivré par le comparateur de sortie précité, possède une forte ondulation crête à crête, lorsque l'équilibre de phase est atteint.

Le signal à intégrer précité, ou signal différentiel, possède ainsi une amplitude crête à crête importante et une fréquence maximale égale à la fréquence élément binaire, ou fréquence bit, du signal de données. Un tel signal est susceptible de constituer une source supplémentaire de "gigue" de phase dans le dispositif et nécessite la mise en oeuvre d'un traitement de filtrage bien adapté. Ce phénomène, désigné par "jitter" en langage anglo-saxon, peut donc se révéler très gênant, notamment lors de la mise en cascade successive de dispositifs de régénération de signal numérique où le phénomène connu d'accumulation systématique de "gigue" de phase peut dégrader le fonctionnement d'une liaison numérique.

La présente invention a pour objet la mise en oeuvre d'un comparateur de phase qui, bien que présentant les avantages du type de comparateur précédent, permet de réduire considérablement le phénomène additionnel de gigue de phase précité.

Le dispositif comparateur de phase entre un signal de données numériques d'entrée et un signal d'horloge délivré par un oscillateur de référence, objet de la présente invention, comprend une première voie formée, d'une part, par une bascule bistable recevant sur une entrée le signal de données numériques et sur une entrée d'horloge le signal d'horloge et délivrant un signal de comparaison, et, d'autre part, par une première porte logique OU exclusif recevant sur une première entrée le signal de données numériques et sur une deuxième entrée le signal de comparaison, cette première voie délivrant un premier signal de détection de transition du signal numérique. Il comprend également une deuxième voie formée, d'une part, par une deuxième porte logique OU exclusif recevant sur une première entrée le signal de données numériques, et, d'autre part, par un circuit de retard ajustable, dont la valeur de retard ajustée est égale à la demi-période du signal d'horloge. Le circuit de retard reçoit le signal de données numériques et délivre un signal de données numériques retardé à une deuxième entrée de la deuxième porte OU exclusif, la deuxième voie délivrant un deuxième signal de détection de transition du signal de données numériques d'entrée.

Le dispositif comparateur de phase, objet de la présente invention, trouve application à la réalisation de circuits intégrés, notamment en technologie CMOS ou BiCMOS. Il sera mieux compris à la lecture de la description et à l'observation des dessins ci-après, dans lesquels, outre la figure 1 relative à l'art antérieur,

- les figures 2a et 2b représentent un schéma synoptique du comparateur de phase, objet de la présente invention, respectivement un chronogramme des signaux de ce comparateur lorsqu'un équilibre de phase entre le signal de données numériques et le signal d'horloge est atteint ;

- la figure 3a représente une variante de réalisation du comparateur de phase, objet de la présente invention, lors de l'utilisation de celui-ci dans une boucle à verrouillage de phase, un oscillateur commandé étant utilisé ;

- la figure 3b représente un détail de réalisation de la figure 3a ;

- la figure 3c représente un mode de réalisation préférentiel du comparateur de phase, objet de la présente invention, dans lequel l'oscillateur commandé est constitué par un oscillateur en anneau ;

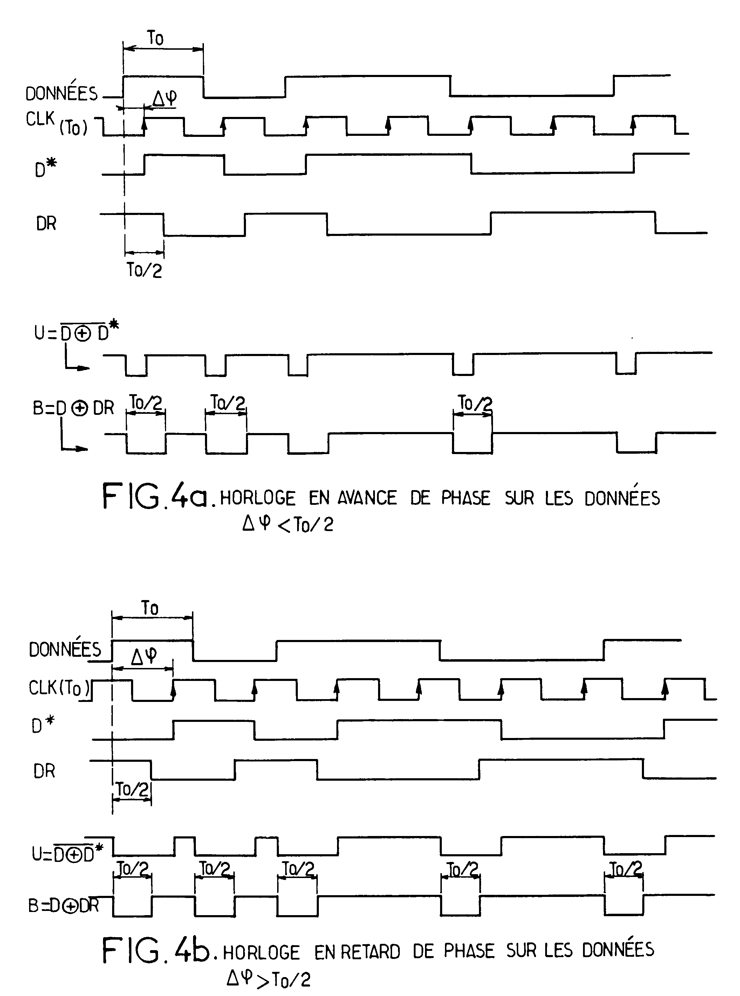

- les figures 4a et 4b représentent un chronogramme des signaux remarquables du comparateur de phase, objet de la présente invention, dans le mode de réalisation de celui-ci illustré en figure 3c, dans le cas où le signal d'horloge est en avance puis en retard de phase respectivement par rapport au signal des données ;

- la figure 5 représente un détail de réalisation avantageux du comparateur de phase, objet de l'invention, tel que représenté en figure 3c, pour des applications très hautes fréquences ;

- les figures 6a et 6b représentent un chronogramme des signaux remarquables du comparateur de phase dans le mode de réalisation de celui-ci représenté en figure 5, dans le cas où le signal d'horloge est en avance puis en retard de phase respectivement par rapport au signal de données numériques.

Une description plus détaillée du dispositif comparateur de phase entre un signal de données numériques d'entrée, référencé par la lettre D, et un signal d'horloge, référencé par les lettres CLK, délivré par un oscillateur de référence, objet de la présente invention, sera maintenant donnée en liaison avec la figure 2a.

Ainsi que représenté sur la figure précitée, on indique que le dispositif comparateur de phase selon l'invention comprend une première voie, notée 1, formée par une bascule bistable portant la référence 10, et par une première porte logique OU exclusif portant la référence 11. La bascule bistable 10 reçoit sur une entrée le signal de données numériques D et sur une entrée d'horloge le signal d'horloge CLK, et délivre un signal de comparaison, noté D*, correspondant.

La première porte logique OU exclusif 11 reçoit sur une première entrée le signal de données numériques D et sur une deuxième entrée le signal de comparaison D*. Elle délivre, en sortie de la première voie, un signal, noté U, constituant un signal de détection de transition du signal numérique vérifiant la relation :

$U = D \oplus D^*$, où $\oplus$ représente l'opérateur OU exclusif.

Le dispositif comparateur de phase, objet de la présente invention, comporte également une deuxième voie, notée 2, formée par une deuxième porte logique OU exclusif, portant la référence 21, recevant sur une première entrée le signal de données numériques D et un circuit de retard, portant la référence 20, dont la valeur de retard est ajustée et égale à la demi-période du signal d'horloge CLK. Le circuit de retard 20 reçoit le signal de données numériques D et délivre un signal de données retardé, noté DR, à la deuxième entrée de la deuxième porte OU exclusif 21. La deuxième porte OU exclusif 21 délivre à sa sortie, et en sortie de la deuxième voie, un autre signal de détection de transition du signal numérique d'entrée, noté B. Le signal de détection U engendre une impulsion à chaque transition du signal de données numériques D dont la durée représente le retard du front montant du signal d'horloge CLK par rapport à chaque transition du signal de données numériques D. Le signal de détection U est donc représentatif du déphasage $\Delta\phi$ entre le signal d'horloge CLK et le signal de données numériques D. Le signal de détection B engendre une impulsion à chaque transition du signal numérique D dont la durée est constante et égale à la valeur de retard du circuit de retard 20. Lorsque la valeur du retard du circuit de retard 20 est ajustée à la valeur de la demi-période $T_o/2$ du signal d'horloge CLK et lorsque l'équilibre de phase est atteint, les signaux de détection U et B sont en phase et idéalement identiques. Comparativement aux signaux de détection du comparateur de Hogge, les signaux de détection U et B précités présentent alors l'avantage, du fait de leur mise en phase à l'équilibre, de réduire le phénomène d'ondulation crête à crête du signal d'erreur de commande de l'oscillateur commandé.

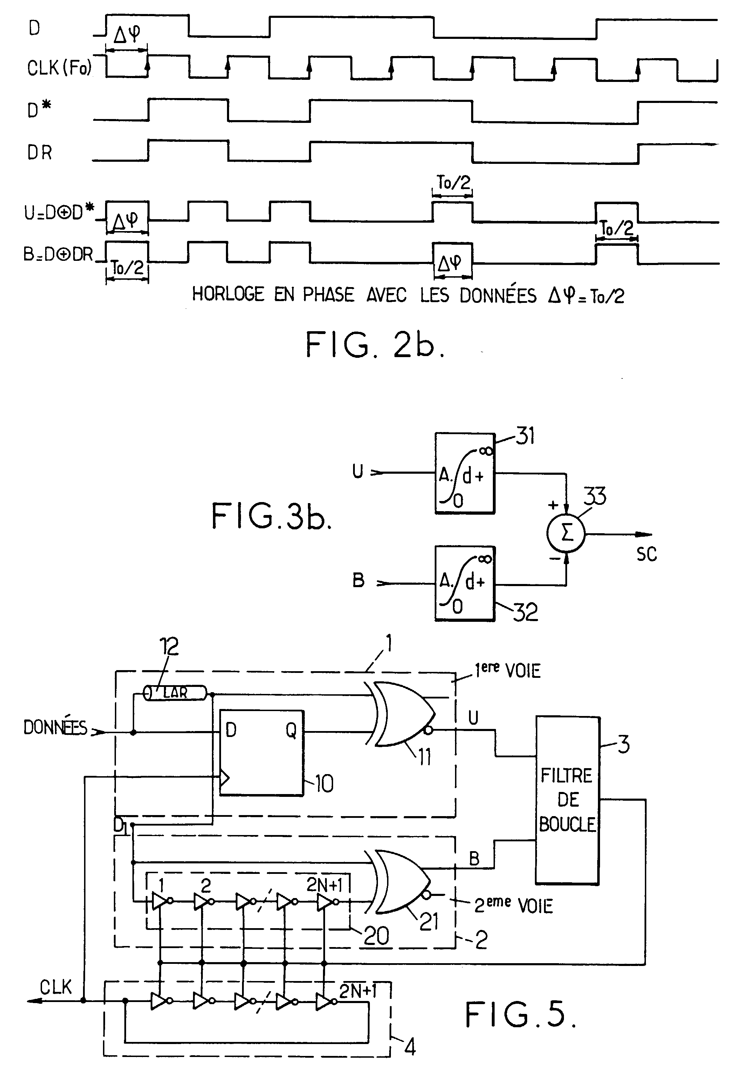

Un chronogramme des différents signaux est représenté en figure 2b lorsque cet équilibre de phase est établi.

Sur la figure 2b, on peut constater que, lorsque la valeur du retard du circuit de retard 20 est égale à une demi-période du signal d'horloge CLK et lorsque l'équilibre de phase est atteint, les fronts montants de l'horloge CLK sont situés idéalement au milieu d'un bit du signal de données numériques D d'une part, et que les fronts montants du signal d'horloge complémenté $\overline{CLK}$ sont situés idéalement au milieu d'un bit des signaux de données numériques D* et DR d'autre part. On indique donc que les signaux de données numériques D, D* ou DR peuvent être utilisés en tant que signaux de données numériques resynchronisés relativement au signal d'horloge CLK ou $\overline{CLK}$.

D'une manière générale, on indique d'une part, que le signal d'horloge CLK est un signal à fréquence stabilisée qui présente un rapport cyclique idéalement égal à 1/2. Il est délivré par un oscillateur de référence, lequel est un oscillateur à fréquence centrale stable.

A titre d'exemple non limitatif, on indique que l'oscillateur de référence présentant une fréquence centrale stable peut être réalisé à partir d'un oscillateur à quartz commandé de type VCXO.

D'une manière générale, on indique d'autre part, que la valeur du retard du circuit de retard 20 est égale à une demi-période du signal d'horloge CLK, et que ce circuit de retard 20 peut être réalisé extérieurement ou intérieurement à la puce de silicium.

A titre d'exemple non limitatif, on indique que le circuit de retard 20 peut être programmable et extérieur au silicium, et de ce fait précis mais non intégrable monolithiquement, ou peut être intégré monolithiquement sous la forme d'un retard analogique résultant ou d'un temps de propagation de portes logiques, et de ce fait peu précis et très sensible aux variations de température et de procédé technologique.

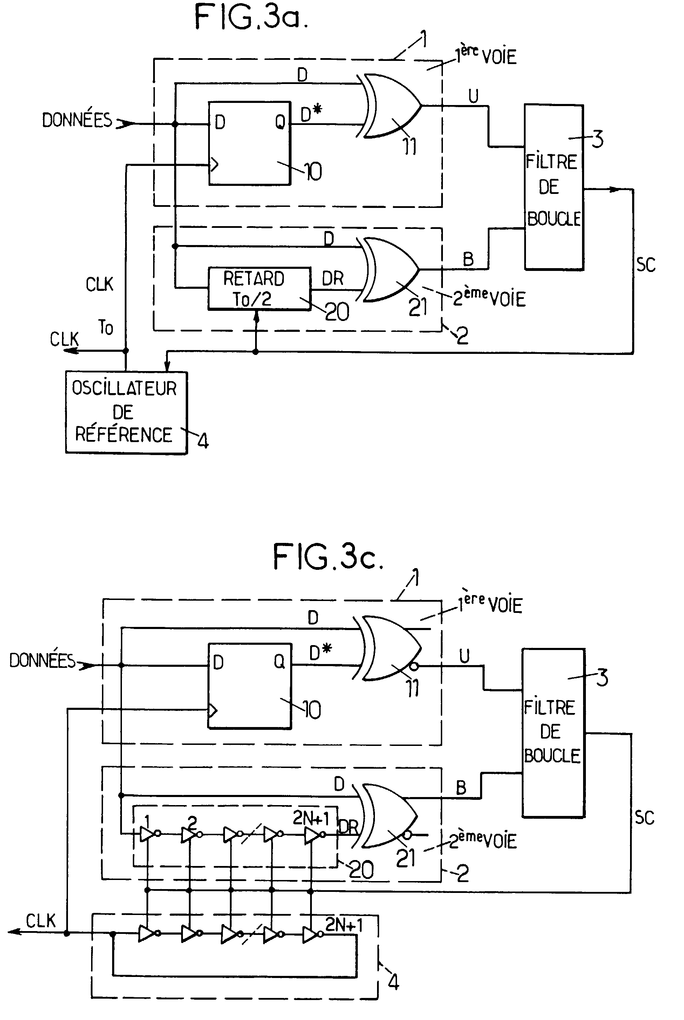

Afin de remédier aux difficultés précédemment citées, conformément à un aspect particulièrement avantageux du dispositif comparateur de phase, objet de la présente invention, on indique que celui-ci peut, de manière particulièrement utile, être intégré à une boucle à verrouillage de phase, laquelle sera décrite en liaison avec les figures 3a et 3b par exemple.

Dans ce but, on indique que l'oscillateur de référence 4 délivrant le signal d'horloge CLK, peut être un oscillateur commandé, de type VCO, lequel délivre le signal d'horloge CLK à la fréquence $F_o$ (période $T_o$).

Dans ce cas, ainsi que représenté en figure 3a, le dispositif comparateur de phase selon l'invention, comprend en outre un circuit de filtrage de boucle 3 recevant les signaux U et B délivrés par la première et par la deuxième voie, ce circuit de filtrage 3, constituant un filtre de boucle, dont le schéma fonctionnel est représenté en figure 3b, délivrant un signal de commande, noté SC, ce signal de commande délivré à l'entrée de l'oscillateur commandé 4 permettant de former une boucle à verrouillage de phase. D'une manière pratique, on indique que l'oscillateur commandé 4 peut être commandé soit en tension, soit en courant.

On comprend ainsi que, grâce au signal de commande SC, la fréquence et la phase du signal d'horloge CLK peuvent être régulées et asservies à une valeur de consigne. Pour assurer l'asservissement de phase, c'est-à-dire la coïncidence du front montant du signal d'horloge CLK avec la position centrale d'un bit du signal de données, ainsi que représenté en figure 2b, le signal de commande SC est également délivré à une entrée de commande du circuit de retard 20, pour assurer une commande correspondante de la valeur de retard apportée par ce circuit de retard à une valeur constante $T_o/2$.

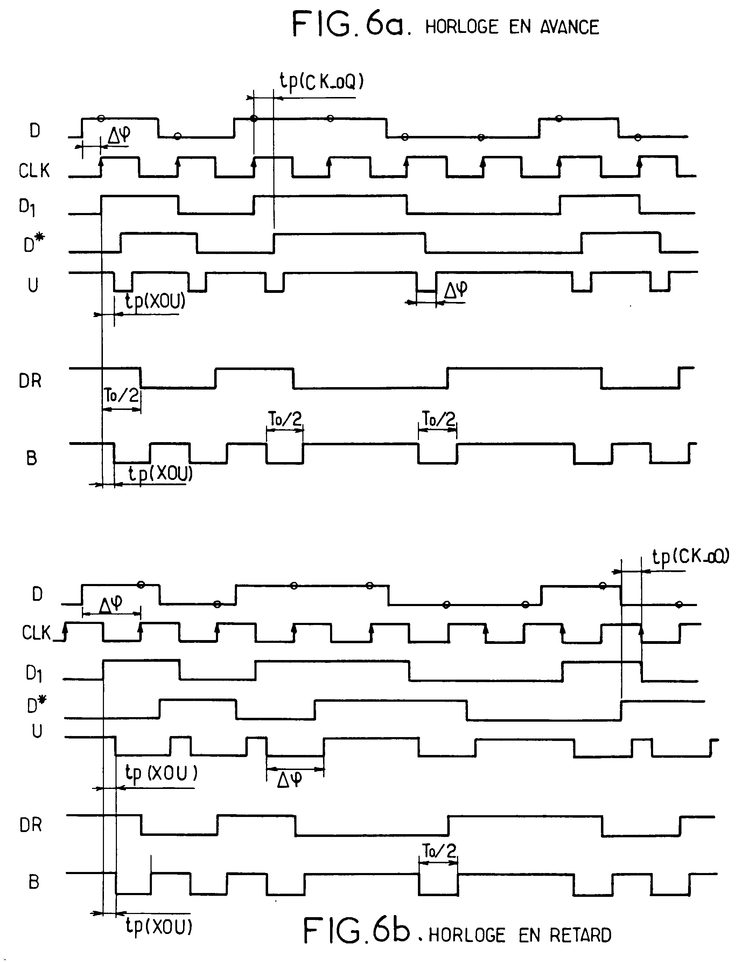

Dans le mode de réalisation précité, relatif à la figure 3a, et dans le but d'assurer l'asservissement de phase ou l'accrochage de l'oscillateur de référence sur la bonne fréquence d'extraction, on indique que l'oscillateur commandé doit être initialement au processus d'accrochage de la boucle à verrouillage de phase, prépositionné à une valeur de fréquence égale à ou très voisine de la fréquence finale $F_o$ à extraire. On indique également à titre d'exemple que ce prépositionnement initial de la fréquence centrale peut être assuré, soit par l'utilisation d'un oscillateur de référence à quartz de type VCXO, soit par un dispositif automatique de prépositionnement initial de la fréquence centrale, ou par un réglage manuel. On indique enfin que ces différents dispositifs d'aide à l'acquisition du rythme des boucles à verrouillage de phase présentées sur les figures 3a, 3c, 5, ne sont pas décrits, car connus de l'état de la technique.

Suite au prépositionnement de la fréquence de l'oscillateur de référence à une valeur voisine de la valeur $F_o$, on indique que, relativement à la figure 3a, le signal de commande SC obtenu après filtrage des signaux U et B issus du comparateur de phase, a des variations sensiblement proportionnelles à l'erreur de phase existante $\Delta\phi$ entre le signal de données numériques D et le signal d'horloge CLK. Lorsque l'équilibre de phase est atteint, le signal de données D et le signal d'horloge CLK présentent un déphasage statique $\Delta\phi = T_o/2$, ainsi que représenté sur les chronogrammes de la figure 2b. On précise également que lorsque l'équilibre de phase est atteint, les deux signaux U et B issus du comparateur de phase ont alors une valeur moyenne identique.

Afin de réaliser le filtre de boucle 3, on indique que celui-ci peut comporter, de manière avantageuse non limitative, ainsi que représenté en figure 3b, un circuit intégrateur 31 recevant le signal U et délivrant un signal correspondant intégré, et un circuit intégrateur 32 recevant le signal B et délivrant un signal correspondant intégré. Un circuit soustracteur 33 reçoit les signaux intégrés délivrés par le circuit intégrateur 31 et le circuit intégrateur 32 pour délivrer le signal de commande SC. L'ensemble des circuits précités peut être par exemple réalisé sous forme de filtre actif différentiel intégrateur ou sous forme de pompe de charge.

Un mode de réalisation préférentiel du dispositif comparateur de phase, objet de l'invention, sera maintenant décrit en liaison avec la figure 3c. Dans la figure 3c, les mêmes références désignent les mêmes éléments que dans la figure 3a par exemple.

Ainsi que représenté sur la figure précitée, on indique que le circuit de retard 20 est un circuit de retard ajustable, formé par un nombre donné de circuits inverseurs, chaque circuit inverseur étant noté de 1 à 2N+1. Les circuits inverseurs sont connectés en cascade et en nombre impair et apportent un retard élémentaire de commutation correspondant. Chaque circuit inverseur 1 à 2N+1 est commandé en tension par le signal de commande SC. Chaque circuit inverseur apportant un retard proportionnel à la tension de commande SC, le retard global apporté par les circuits inverseurs connectés en cascade peut ainsi être ajusté par rapport à une valeur moyenne.

De même, ainsi que représenté sur la figure 3c précitée, on indique que l'oscillateur de référence 4 peut, de manière particulièrement avantageuse, être constitué par un oscillateur en anneau formé par un nombre impair d'inverseurs, chacun des inverseurs étant également commandé en tension par le signal de commande SC.

Les inverseurs constitutifs de l'oscillateur en anneau sont connectés en cascade, la sortie du dernier inverseur étant rebouclée sur l'entrée du premier. Bien entendu, le nombre d'inverseurs formant le circuit de retard et l'oscillateur en anneau est identique, les inverseurs étant en outre appariés. De même que l'oscillateur commandé 4, les inverseurs peuvent être commandés soit en tension, soit en courant.

Pour un temps de propagation $Tp_i$ d'un inverseur élémentaire de base constitutif du dispositif de retard 20, respectivement de l'oscillateur en anneau 4, lorsque ce dernier est commandé en tension ou en courant par le signal de commande SC, et pour une valeur de retard global apporté par les 2N+1 inverseurs égale à $T_o/2$, l'oscillateur en anneau oscille à la fréquence d'horloge $F_o$ correspondante, le retard global apporté étant égal à une demi-période du signal d'horloge $T_o/2$. Dans ce cas, la fréquence du signal d'horloge qui est délivré par l'oscillateur en anneau 4 vérifie la relation :

$$F_0 = \frac{1}{2(2N+1)Tp_i}$$

relation dans laquelle $Tp_i$ désigne le temps de propagation ou de retard apporté par chaque inverseur élémentaire commandé par la valeur de la tension du signal de commande SC.

Le dispositif, objet de la présente invention, tel que représenté en figure 3c, est particulièrement avantageux dans la mesure où celui-ci peut être directement intégré dans un circuit intégré pour assurer, à partir d'un signal de données numériques, la régénération locale d'un signal d'horloge de référence, ce signal étant bien entendu synchronisé sur le signal de données D.

Enfin, ainsi que représenté en figure 5, on précise, pour des applications hautes fréquences où les temps de propagation des éléments logiques du comparateur de phase ne sont plus négligeables devant la période du signal d'horloge CLK, qu'il est avantageux de prévoir un circuit de retard de compensation 12 sur l'entrée de données du premier circuit OU exclusif 11. Ce circuit de retard 12 permet de compenser le retard introduit par le circuit de bascule 10 en ajoutant sur le trajet des données un retard de valeur déterminée, sensiblement égal au retard introduit par le circuit de bascule 10 précité. Les chronogrammes des signaux remarquables du comparateur de phase relatif à la figure 5 sont indiqués sur les figures 6a et 6b, respectivement lorsque le signal d'horloge CLK est en avance et en retard de phase par rapport au signal de données numériques. Dans le cas des figures 6a et 6b, le retard introduit par le circuit de retard de compensation 12 compense le temps de propagation de la bascule. Ce temps de propagation tp (CK→Q) étant supposé égal à 1/4 de la période du signal d'horloge. Sur ces figures, tp(XOU) désigne le temps de propagation des portes OU exclusif. On indique également que le circuit de retard 12 peut être facilement réalisé sous la forme, soit de temps de propagation de portes logiques intégrables monolithiquement et permettant de compenser les variations du temps de propagation de la bascule 10, soit de circuits de type RC dont l'intégration monolithique reste délicate.

On a ainsi décrit un dispositif comparateur de phase entre un signal numérique et un signal d'horloge particulièrement avantageux dans la mesure où, bien que les performances des circuits antérieurs tels que les circuits décrits par l'article de Hogge précédemment mentionné dans la description soient conservées, c'est-à-dire :

- centrage automatique d'un front actif de l'horloge en milieu d'un bit,
- grande excursion statique de phase du comparateur de -180° à +180°,
- simplicité semblable,
- absence d'introduction d'un retard extérieur, non réalisable sous forme de circuit intégré,
- indépendance du débit des données dans la plage de fonctionnement commandé précitée,

les avantages relatifs à la suppression des déphasages de 180° entre les signaux U et B à l'équilibre de phase sont obtenus, ce qui permet de réduire l'ondulation crête à crête du signal d'erreur de commande SC de l'oscillateur de référence et donc d'améliorer les performances en "jitter" ou gigue de phase de l'ensemble du système.

## Revendications

1. Dispositif comparateur de phase entre un signal de données numériques d'entrée et un signal d'horloge délivré par un oscillateur de référence (4), comprenant :

- une première voie (1) formée par

  . une bascule bistable (10) recevant sur une entrée ledit signal de données numériques et sur une entrée d'horloge ledit signal d'horloge et délivrant un signal de comparaison,
  . une première porte logique OU exclusif (11) recevant sur une première entrée ledit signal de données numériques et sur une deuxième entrée ledit signal de comparaison, ladite première voie délivrant un premier signal (U) de détection de transition du signal numérique, et

- une deuxième voie (2),

caractérisé en ce que la deuxième voie est formée par

  . une deuxième porte logique OU exclusif (21) recevant sur une première entrée le signal de données numériques,
  . un circuit de retard (20) dont la valeur de retard est ajustée et égale à la demi-période dudit signal d'horloge, ledit circuit de retard recevant ledit signal de données numériques et délivrant un signal de données numériques retardé à une deuxième entrée de ladite deuxième porte OU exclusif, ladite deuxième voie délivrant un deuxième signal (B) de détection de transition du signal numérique d'entrée.

2. Dispositif selon la revendication 1, caractérisé en ce que ledit oscillateur de référence (4) est un oscillateur à fréquence centrale stabilisée.

3. Dispositif selon la revendication 1 ou 2, caractérisé en ce que ledit oscillateur de référence (4) est un oscillateur commandé et en ce que ledit dispositif comprend en outre un circuit de filtrage de boucle (3), recevant le signal délivré par la première et la deuxième voie et délivrant un signal de commande, délivré à l'entrée dudit oscillateur commandé, ce qui permet de former une boucle à verrouillage de phase.

4. Dispositif selon la revendication 3, caractérisé en ce que le circuit de retard (20) est un circuit de retard ajustable formé par un nombre N de circuits inverseurs connectés en cascade, chaque inverseur apportant un retard élémentaire de commutation étant commandé par ledit signal de commande.

5. Dispositif selon la revendication 3 ou 4, caractérisé en ce que ledit oscillateur de référence (4) est un oscillateur en anneau formé par un nombre impair d'inverseurs, chaque inverseur étant commandé par ledit signal de commande.

6. Dispositif selon la revendication 5, caractérisé en ce que le nombre d'inverseurs formant ledit circuit de retard (20) et ledit oscillateur en anneau est identique, lesdits inverseurs étant appariés.

7. Utilisation d'un dispositif, selon l'une des revendications 1 à 6, dans un circuit intégré pour assurer, à partir d'un signal de données numériques, la régénération locale d'un signal d'horloge de référence.

**Patentansprüche**

1. Anordnung zum Vergleichen der Phase zwischen einem digitalen Eingangsdatensignal und einem von einem Bezugsoszillator (4) bereitgestellten Taktsignal, umfassend:

- einen ersten Pfad (1), der gebildet ist von

  - einem bistabilen Kippglied (10), welches auf einem Eingang das digitale Datensignal und auf einem Takteingang das Taktsignal erhält und ein Vergleichssignal bereitstellt, und
  - einem ersten logischen EXKLUSIV-ODER-Glied (11), welches auf einem ersten Eingang das digitale Datensignal und auf einem zweiten Eingang das Vergleichssignal erhält, wobei dieser erste Pfad ein erstes Signal (U) zur Erfassung eines Übergangs des digitalen Signals bereitstellt, und

- einen zweiten Pfad (2),

dadurch gekennzeichnet, daß der zweite Pfad gebildet ist von

- einem zweiten logischen EXKLUSIV-ODER-Glied (21), welches auf einem ersten Eingang das digitale Datensignal erhält, und
- einer Verzögerungsschaltung (20), deren Verzögerungswert eingestellt ist und gleich der halben Periode des Taktsignals ist, wobei die Verzögerungsschaltung das digitale Datensignal erhält und ein verzögertes digitales Datensignal einem zweiten Eingang des zweiten EXKLUSIV-ODER-Glieds zuführt, wobei dieser zweite Pfad ein zweites Signal (B) zur Erfassung eines Übergangs des digitalen Eingangssignals bereitstellt.

2. Anordnung nach Anspruch 1, dadurch gekennzeichnet, daß der Bezugsoszillator (4) ein Oszillator mit stabilisierter Mittenfrequenz ist.

3. Anordnung nach Anspruch 1 oder 2, dadurch gekennzeichnet, daß der Bezugsoszillator (4) ein gesteuerter Oszillator ist und daß die Anordnung ferner eine Schleifenfilterschaltung (3) umfaßt, welche das von dem ersten und von dem zweiten Pfad bereitgestellte Signal erhält und ein dem Eingang des gesteuerten Oszillators zugeführtes Steuersignal bereitstellt, was die Bildung einer Phasenverriegelungsschleife ermöglicht.

4. Anordnung nach Anspruch 3, dadurch gekennzeichnet, daß die Verzögerungsschaltung (20) eine einstellbare Verzögerungsschaltung ist, welche von einer Anzahl N in Kaskade verbundener Inverterschaltungen gebildet ist, wobei jeder Inverter eine Grundumschaltverzögerung erbringt und durch das Steuersignal gesteuert wird.

5. Anordnung nach Anspruch 3 oder 4, dadurch gekennzeichnet, daß der Bezugsoszillator (4) ein Ringoszillator ist, welcher von einer ungeraden Anzahl von Invertern gebildet ist, wobei jeder Inverter durch das Steuersignal gesteuert wird.

6. Anordnung nach Anspruch 5, dadurch gekennzeichnet, daß die Anzahl der Inverter, die die Verzögerungsschaltung (20) und den Ringoszillator bilden, identisch ist, wobei die Inverter paarweise angeordnet sind.

7. Verwendung einer Anordnung nach einem der Ansprüche 1 bis 6 in einer integrierten Schaltung, um ausgehend von einem digitalen Datensignal die lokale Regenerierung eines Bezugstaktsignals sicherzustellen.

**Claims**

1. Device for comparing the phase of a digital input data signal with that of a clock signal delivered by a reference oscillator (4), said device including:

- a first channel (1) formed by

  - a bistable flip-flop (10) receiving the said digital data signal on one input and the said clock signal on a clock input and delivering a comparison signal,

. a first exclusive OR logic gate (11) receiving the said digital data signal on a first input and the said comparison signal on a second input, the said first channel delivering a first detection signal (U) of transition of the digital signal, and

- a second channel (2) characterized by said second channel being formed by

. a second exclusive OR logic gate (21) receiving the digital data signal on a first input,

. a delay circuit (20) whose delay value is set and equal to half the period of the said clock signal, the said delay circuit receiving the said digital data signal and delivering a delayed digital data signal to a second input of the said second exclusive OR gate, the said second channel delivering a second detection signal (B) of transition of the digital input signal.

2. Device according to Claim 1, characterized in that the said reference oscillator (4) is an oscillator with stabilized central frequency.

3. Device according to Claim 1 or 2, characterized in that the said reference oscillator (4) is a controlled oscillator and in that the said device furthermore comprises a loop filtering circuit (3), receiving the signal delivered by the first and the second channel and delivering a control signal, delivered to the input of the said controlled oscillator, thereby enabling a phase locked loop to be formed.

4. Device according to Claim 3, characterized in that the delay circuit (20) is an adjustable delay circuit formed by a number N of inverter circuits connected in cascade, each inverter affording an elementary switching delay being controlled by the said control signal.

5. Device according to Claim 3 or 4, characterized in that the said reference oscillator (4) being a ring oscillator formed by an odd number of inverters, each inverter being controlled by the said control signal.

6. Device according to Claim 5, characterized in that the number of inverters forming the said delay circuit (20) and the said ring oscillator being identical, the said inverters being paired.

7. Utilization of a device, according to Claims 1 to 6, within an integrated circuit so as to provide, on the basis of a digital data signal, the local regeneration of a reference clock signal.

COMPARATEUR DE HOGGE, A L'ÉQUILIBRE

FIG.1. (ART ANTERIEUR)

FIG.2a.

HORLOGE EN PHASE AVEC LES DONNÉES $\Delta\varphi = T_0/2$

FIG. 2b.

FIG.3b.

FIG.5.

# FIG.3a.

# FIG.3c.

FIG.4a. HORLOGE EN AVANCE DE PHASE SUR LES DONNÉES

$$\Delta \varphi < T_0/2$$

FIG.4b. HORLOGE EN RETARD DE PHASE SUR LES DONNÉES

$$\Delta \varphi > T_0/2$$

FIG.6a. HORLOGE EN AVANCE

FIG.6b. HORLOGE EN RETARD